# EUROPÄISCHE PATENTSCHRIFT

(11) **EP 0 664 926 B1**
(45) Veröffentlichungstag und Bekanntmachung des Hinweises auf die Patenterteilung: **12.02.1997**
(21) Anmeldenummer: 93921805.3
(22) Anmeldetag: 07.10.1993
(51) Int. Cl.: H01L 31/0236, H01L 31/0216

(54) **VORRICHTUNG ZUR ABSORPTION INFRAROTER STRAHLUNG**
IR-ABSORPTION DEVICE
DISPOSITIF POUR ABSORBER DES RAYONS INFRAROUGES

(30) Priorität: 13.10.1992 DE 4234471
(43) Veröffentlichungstag der Anmeldung: 02.08.1995
(73) Patentinhaber: FRAUNHOFER-GESELLSCHAFT ZUR FÖRDERUNG DER ANGEWANDTEN FORSCHUNG E.V., 80636 München (DE)
(72) Erfinder: MÜLLER, Michael, D-01109 Dresden (DE); GOTTFRIED-GOTTFRIED, Ralf, D-35576 Wetzlar (DE); KÜCK, Heinz, D-47249 Duisburg (DE)
(86) Internationale Anmeldenummer: DE9300954
(87) Internationale Veröffentlichungsnummer: WO9409517

(56) Entgegenhaltungen:
- EP-A- 0 253 002
- DE-A- 3 827 576
- US-A- 4 158 133
- US-A- 4 558 342
- US-A- 4 608 451
- 1992 IEEE INTERNATIONAL SYMPOSIUM ON CIRCUITS AND SYSTEMS Bd. 4 , 10. Mai 1992 , SAN DIEGO,CA,US Seiten 1820 - 1823 BALTES ET AL. 'SILICON MICROSENSORS AND MICROSTRUCTURES'
- PATENT ABSTRACTS OF JAPAN vol. 9, no. 109 (P-355)(1832) 14. Mai 1985 & JP,A,59 230 123 (KOGYO GIJUTSUIN) 24. Dezember 1984
- INFRARED PHYSICS Bd. 30, Nr. 6 , 1990 , OXFORD Seiten 465 - 478 HADNI ET AL. 'INFRARED AND MILLIMETER WAVE ABSORBER STRUCTURES FOR THERMAL DETECTORS' in der Anmeldung erwähnt
- IEEE TRANSACTIONS ON ELECTRON DEVICES Bd. 39, Nr. 5 , Mai 1992 , NEW YORK US Seiten 1100 - 1107 SAHA ET AL. 'INFLUENCE OF SURFACE TEXTURIZATION ON THE LIGHT TRAPPING AND SPECTRAL RESPONSE OF SILICON SOLAR CELLS' in der Anmeldung erwähnt

## Beschreibung

### Technisches Gebiet:

Die Erfindung betrifft eine Vorrichtung zur Absorption infraroter Strahlung, die mit Materialien und Verfahren der CMOS-Technologie hergestellt werden kann. Thermische Infrarotdetektoren auf der Basis von Thermopiles (Thermosäulen) werden als kostengünstige Detektoren in breitem Umfang produziert und eingesetzt. Die Umwandlung der Strahlungsenergie der Infrarotstrahlung in thermische Energie erfolgt in sogenannten Infrarotabsorbern.

### Stand der Technik

Die am häufigsten eingesetzten Infrarotabsorber sind schwarze Metallschichten (z.B. Au, Ag, Pt), die durch Aufdampfen unter einem bestimmten Fremdgasdruck hergestellt werden. Die sehr hohe und gleichmäßige Infrarotabsorption wird durch die Porosität der Schichten erreicht. Der Nachteil dieser Absorberschichten liegt in ihrer Empfindlichkeit gegen mechanische und chemische Einflüsse, so daß die Herstellung einer definierten Geometrie des Absorbers mit Verfahren der CMOS-Technologie nur durch das Aufdampfen über eine Lochmaske möglich ist, was zu Einschränkungen in der Technologie führt. Ein anderes Verfahren zur Herstellung poröser Metallschichten besteht in der elektrolytischen Abscheidung. Die Probleme dieses Verfahrens bestehen unter anderem in ionischen Verunreinigungen des Elektrolyten, in der Spannungsbelastung des i. a. scheibenförmigen Trägers der Metallschichten (z. B. Siliziumwafer) bei der Elektrolyse und darin, daß zur elektrolytischen Schichtabscheidung Hilfsebenen benötigt werden. Dies ist gegenwärtig kein Standard der CMOS-Technologie.
In der Literatur wird die Möglichkeit der Infrarotabsorption durch dünne Metallschichten und λ/4-Schichten beschrieben (z.B. A. Hadni and X. Gerbaux, Infrared and Millimeter Wave Absorber Structure for Thermal Detectors, Infrared Phys. Vol.30, No.6 (1990), pp. 465-478). Durch dünne Metallfilme kann eine gleichmäßige Absorption für Wellenlängen oberhalb 1 µm erzeugt werden, die jedoch höchstens 50% beträgt. Mit Antireflexschichten λ/4-Schichten) können die Reflexionsverluste an den Absorberoberflächen verringert werden. Der Absorptionsgrad der dünnen Metallschichten hängt jedoch empfindlich von der Schichtdicke ab, so daß für ihre Herstellung eine genaue Schichtdickensteuerung nötig ist.
Eine weitere Gruppe von Infrarotabsorbern besteht aus organischen Schichten wie Kohlenwasserstoffrußen und sogenannten Schwarzlacken. Für die Abscheidung und Strukturierung dieser Schichten gibt es gegenwärtig keine CMOS-kompatiblen Technologien.
In H. Saha et al, Influence of Surface Texturization on the Light Trapping and Spectral Response of Silicon Solar Cells, IEEE Transactions on Electron Devices, Vol. 39, No.5 (1992), pp. 1100-1106 wird eine Absorberstruktur beschrieben, deren Oberfläche pyramidenförmige Rillen oder Vertiefungen aufweist, die durch anisotropes Ätzen in einkristallinem Silizium gebildet werden. Der Nachteil dieser Struktur liegt darin, daß für ihre Herstellung zunächst eine einkristalline Siliziumschicht aufgebracht werden muß, ein Prozeßschritt, der zusätzlichen technologischen Aufwand erfordert.

Aus der US-A-4 620 364 sind Solarzellen bekannt, die eine mittlere monokristalline Schicht (z. B. Silizium-Kristall) sowie eine obere und untere, nicht absorbierende Schicht aufweisen, die beide strukturiert sein können. Durch Mehrfachreflexion der Infrarotstrahlung zwischen oberer und unterer Schicht wird die optische Weglänge der Strahlung in der absorbierenden mittleren Schicht erhöht und somit die Effizienz der Solarzelle verbessert.

Eine solche Anordnung kann nicht in praktikabler Weise auf einem Trägerkörper (z. B. eine Membran) aufgebracht werden, wie es für den Einsatz als thermischer Detektor notwendig wäre. Die Aufbringung einer einkristallinen Schicht, z. B. aus Silizium, ist, wie bereits oben erwähnt, mit erhöhtem technischen Aufwand verbunden.

### Darstellung der Erfindung:

Aufgabe der vorliegenden Erfindung ist es daher, eine Vorrichtung zur Umwandlung infraroter Strahlung in thermische Energie für thermische Detektoren anzugeben, die eine große Bandbreite und hohe Absorption aufweist, und die auf einfache Weise mit bekannten Technologien herstellbar ist.

Diese Aufgabe wird erfindungsgemäß durch die Vorrichtung zur Absorption infraroter Strahlung, im folgenden auch Absorberstruktur genannt, mit den im Anspruch 1 angegebenen Merkmalen gelöst. Die erfindungsgemäße Vorrichtung besteht aus drei Grundelementen. Das untere Element ist eine Schicht mit einem geringen Transmissionskoeffizienten für die zu absorbierende Infrarotstrahlung. Sie absorbiert einen Teil der einfallenden Strahlung und reflektiert den nicht absorbierten Anteil zurück in die über ihr liegenden Elemente. Das mittlere Element wird durch eine Schicht mit einem hohen Absorptions- und einem geringen Reflexionskoeffizienten für die zu absorbierende Strahlung gebildet. Sie bewirkt in erster Linie Absorption und dient als Abstandshalter zwischen oberem und unterem Element. Das obere Element dient der Absorption der von oben auf die Vorrichtung einfallenden und der von den unteren Elementen kommenden Streustrahlung und reflektiert die von den unteren Absorberelementen kommende, nicht absorbierte Strahlung zurück in die Absorberstruktur. Das obere Element muß so gestaltet sein, daß die von oben auf dieses Element einfallende Strahlung in möglichst geringem Maße reflektiert wird. Bevorzugte Ausgestaltungen des oberen Elements sind in den Ansprüchen 2 und 3 angegeben.
Durch Vielfachreflexion der einfallenden Infrarotstrahlung zwischen den einzelnen Elementen der erfindungsgemäßen Vorrichtung erhöht sich in vorteilhafter Weise deren Gesamtabsorptionsgrad. Die erfindungsgemäße Vorrichtung zeigt Absorption über einen großen Wellenlängenbereich.

Die vorliegende erfindungsgemäße Vorrichtung läßt sich mit Materialien und Verfahren der CMOS-Technologie ohne Einschränkungen herstellen. Als Beispiel dafür sei auf das Ausführungsbeispiel verwiesen. Damit läßt sich der Herstellungsprozeß in vorteilhafter Weise ohne zusätzlichen Aufwand in einen CMOS-Zyklus integrieren. Die kostengünstige, durchgängige Produktion von thermischen Infrarotdetektoren in CMOS-Technologie, z. B. auf der Basis von Thermopiles, wird somit ermöglicht.

In Weiterbildung der erfindungsgemäßen Vorrichtung weist die mittlere Schicht gemäß Anspruch 2 Vertiefungen auf, wobei das obere Element durch eine Beschichtung der Wände dieser Vertiefungen mit Metall gebildet wird. Diese Vertiefungen können z.B. rasterförmig angeordnet sein. Das obere Element wirkt in dieser Ausgestaltung auf die einfallende Strahlung wie eine Anordnung von Hohlräumen. Vielfachreflexion der Strahlung in den Hohlräumen erhöht die Absorption, so daß der Absorptionsgrad des einzelnen Hohlraumes über dem des eingesetzten Wandmaterials (Metallschicht) liegt.

Eine weitere Ausführungsform des oberen Elementes der erfindungsgemäßen Vorrichtung ist in Anspruch 3 angegeben. Das obere Element wird demgemäß durch eine auf die mittlere Schicht aufgebrachte Aluminiumschicht gebildet, die durchgehende Vertiefungen (Durchgangsöffnungen) aufweist, die in der Tiefe nur durch die darunterliegende mittlere Schicht begrenzt sind. Die Vertiefungen können z. B. rasterförmig oder wabenförmig angeordnet sein. Auf der Aluminiumschicht ist eine dünne Oxid-Schutzschicht abgeschieden, die die Oberflächenstruktur des oberen Elementes nicht verändert.

Eine bevorzugte Ausgestaltung der erfindungsgemäßen Vorrichtung wird nach Anspruch 4 durch ausschließliche Verwendung von Materialien und Verfahren der CMOS-Technologie erreicht. Damit lassen sich, wie bereits oben beschrieben, integrierte thermische Infrarotdetektoren kostengünstig herstellen.

Bei einer vorteilhaften Ausgestaltung der erfindungsgemäßen Vorrichtung wird, wie in Anspruch 5 beschrieben, die untere Schicht durch eine Aluminiumschicht mit einer Dicke von 1 µm realisiert. Die mittlere Schicht ist eine Oxidschicht mit einer Dicke zwischen 2 und 8 µm. Das obere Element wird durch ein Raster von Vertiefungen in der mittleren Schicht gebildet, deren Wände (d. h. auch der Bo - den) mit einer 500 nm dicken Aluminiumschicht bedeckt sind. Die Ränder der Vertiefungen haben rechteckige Querschnitte mit einer Kantenlänge von 2 bis 4 µm und sind in einem gegenseitigen Abstand von 2 bis 10 µm rasterförmig angeordnet.

Anspruch 6 gibt eine vorteilhafte Ausführungsform der erfindungsgemäßen Vorrichtung an, bei der die Vertiefungen in der mittleren Schicht mit einem Planarisierungsoxid (z.B. SiO₂) aufgefüllt sind. Bei Anwendung der im ersten Ausführungsbeispiel beschriebenen Herstellungsvariante der erfindungsgemäßen Anordnung, ist diese Ausführungsform technologisch bedingt. Das Vorhandensein des Planarisierungsoxides in den Vertiefungen führt vorteilhafterweise zur zusätzlichen Dämpfung und somit zur Erhöhung der Absorption der einfallenden Strahlung.

Im folgenden wird die Erfindung anhand zweier Ausführungsbeispiele und der Zeichnungen näher erläutert.

Dabei zeigen:
- Figur 1:: einen Querschnitt durch die Absorberstruktur eines Ausführungsbeispiels,
- Figur 2:: eine Draufsicht auf die Absorberstruktur aus Fig. 1,
- Figur 3:: ein gemessenes Absorptionsspektrum der Absorberstruktur des Ausführungsbeispiels,
- Figur 4:: das Verhältnis der von der Absorberstruktur des Ausführungsbeispiels absorbierten Strahlungsleistung zu der von einem schwarzen Körper absorbierten Strahlungsleistung,
- Figur 5a:: einen Querschnitt durch die Absorberstruktur eines weiteren Ausführungsbeispiels, und
- Figur 5b:: eine Draufsicht auf das obere Element der Absorberstruktur aus Figur 5 a.

### Ausführungsbeispiele:

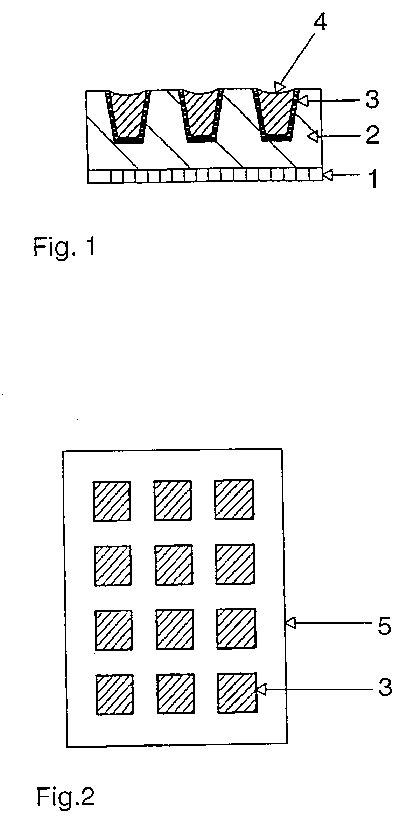

Ein Ausführungsbeispiel für die erfindungsgemäße Anordnung zur Absorption infraroter Strahlung ist in Figur 1 im Querschnitt dargestellt. Das untere Element wird hier durch eine Aluminiumschicht 1 mit einer Dicke von 1 µm realisiert. Die mittlere Schicht 2 ist eine Oxid- oder Nitridschicht mit einer Dicke zwischen 2 und 8 µm. Die mittlere Schicht 2 weist Vertiefungen auf (mit einer Tiefe im µ mBereich), deren Wände mit einer 500 nm dicken Aluminiumschicht bedeckt sind. Das obere Element 3 wird durch diese Aluminiumbeschichtung der Wände der Vertiefungen gebildet. Die Ränder der Vertiefungen haben rechteckige Querschnitte, wie in Figur 2 in Draufsicht gezeigt, mit einer Kantenlänge von 2 bis 4 µm und sind in einem gegenseitigen Abstand von 4,8 bis 8,8 µm rasterförmig angeordnet. In den Vertiefungen befindet sich ein Planarisierungsoxid 4, welches technologisch bedingt ist. In Figur 2 ist außerdem der Rand 5 der unteren Aluminiumschicht zu sehen.
Die Technologie zur Herstellung der Absorberstruktur dieses Ausführungsbeispieles sei im folgenden kurz erläutert.
Auf einen Siliziumwafer wird die 1 µm dicke Aluminiumschicht gesputtert, auf welche durch einen CVD-Prozeß die 2 bis 8 µm dicke Oxidschicht (SiO₂) abgeschieden wird. In das Oxid werden in einem Plasma-Ätzprozeß Vertiefungen über eine Lackmaske geätzt. Dies entspricht einer Kontaktfenstertechnologie. Nach der Restlackentfernung wird ein 500 nm dicker Aluminiumfilm auf die Struktur gesputtert. Anschließend erfolgt die Abscheidung eines Planarisierungsoxides (z.B. SiO₂), welches plasmachemisch zurückgeätzt wird, so daß das Planarisierungsoxid nur noch in den Vertiefungen vorhanden ist. Das Planarisierungsoxid bedeckt die Aluminiumschicht in den Vertiefungen, während sie zwischen den Vertiefungen freigelegt ist. Das Planarisierungsoxid bildet auf diese Weise die Ätzmaske für den abschließenden Aluminium-Ätzprozeß, nach dessen Durchführung das Aluminium des oberen Elementes nur noch an den Wänden der Vertiefungen vorhanden ist.

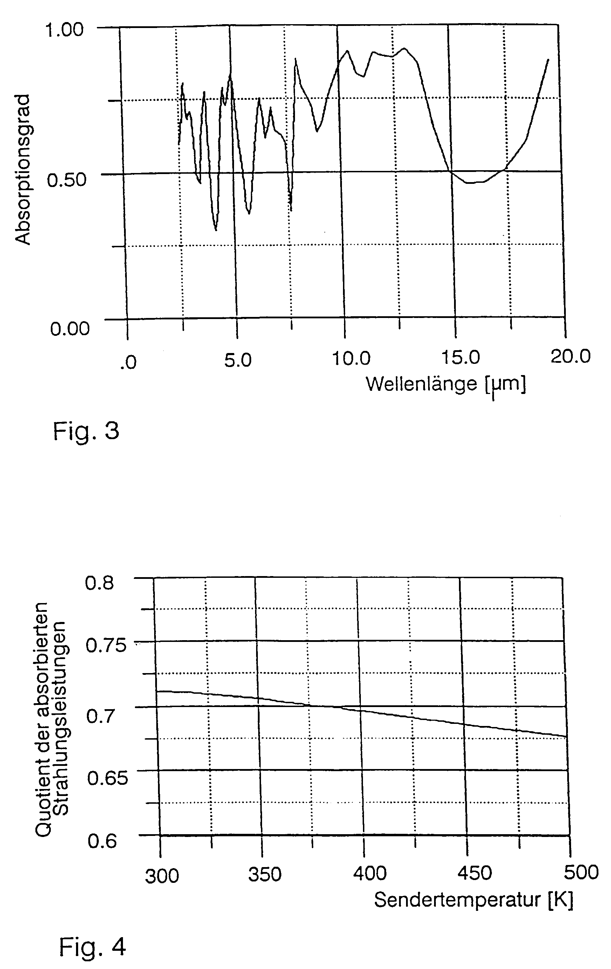

Ein Absorptionsspektrum der Absorberstruktur des Ausführungsbeispiels ist in Figur 3 dargestellt. In dieser Figur ist der Absorptionsgrad der Absorberstruktur in Abhängigkeit von der Wellenlänge der einfallenden Strahlung aufgetragen. Die Abbildung zeigt, daß die Herstellung eines Infrarotabsorbers mit einer großen Absorptionsbandbreite mit der erfindungsgemäßen Absorberstruktur ohne Einschränkungen in CMOS-Technologie möglich ist.

In Figur 4 ist das Verhältnis der von der Absorberstruktur des Ausführungsbeispiels absorbierten Infrarotstrahlungsleistung zu der von einem schwarzen Strahler absorbierten Strahlungsleistung in Abhängigkeit von der Temperatur eines Senders mit dem Emissionskoeffizienten = 1 aufgetragen. Der Wirkungsgrad der erfindungsgemäßen Absorberstruktur ist somit weitgehend unabhängig von der Sendertemperatur.

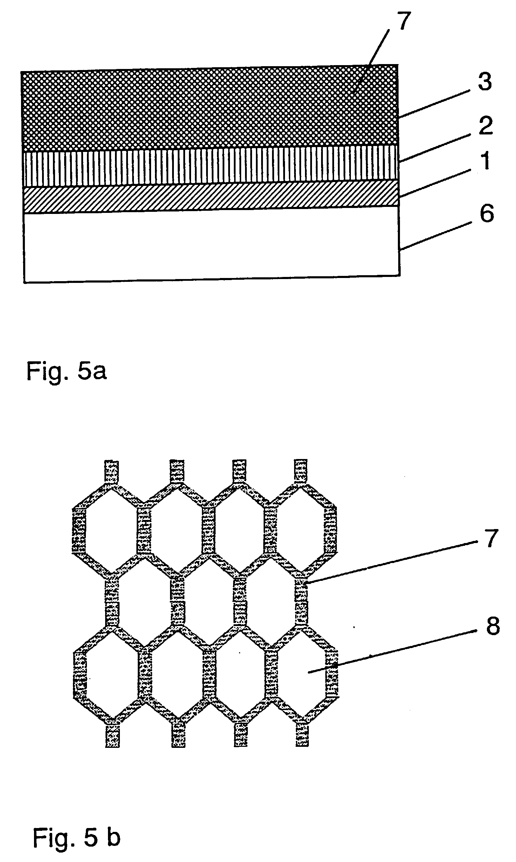

Figur 5 a zeigt schematisch ein weiteres Ausführungsbeispiel für die erfindungsgemäße Struktur. Die verschiedenen Schichten der Absorberstruktur sind auf einer Siliziummembran 6 als Trägerkörper aufgebracht. Die untere Schicht 1 besteht aus einer Aluminiumschicht mit einer Dicke von etwa 500 nm, die mittlere Schicht 2 aus einer SiO₂-Schicht mit einer Dicke von etwa 750 nm, die in der gleichen Weise wie bereits im ersten Ausführungsbeispiel beschrieben auf die Siliziummembran 6 aufgebracht wurden. Das obere Element 3 setzt sich aus einer etwa 2 µm dicken Aluminiumschicht 7 und einer darüberliegenden SiO₂-Schutzschicht (in Figur 5 a nicht gezeigt) mit einer Dicke von ca. 750 nm zusammen. Die Aluminiumschicht weist eine wabenförmige Struktur mit durchgehenden Vertiefungen 8 (Löchern) auf (in Figur 5 a nicht gezeigt). Die wabenförmige Struktur der Aluminiumschicht 7 ist in Figur 5 b mit den durchgehenden Vertiefungen 8 dargestellt. Das Aufbringen der Aluminiumschicht des oberen Elementes auf die mittlere Schicht erfolgt durch Sputtern. Die Schicht wird zur Erzeugung der wabenförmigen Struktur mit herkömmlichen Verfahren maskiert und RIE-strukturiert. Die abschließende SiO₂-Schutzschicht wird mittels CVD abgeschieden.

## Patentansprüche

1. Vorrichtung zur Umwandlung infraroter Strahlung in thermische Energie für thermische Detektoren, bestehend aus einem Trägerkörper (6), auf dem vom Trägerkörper her eine untere Schicht (1), eine auf der unteren Schicht (1) angeordnete mittlere Schicht (2) und ein auf der mittleren Schicht (2) angeordnetes, der einfallenden Strahlung zugewandtes oberes Element (3) aufgebracht sind, wobei
- die untere Schicht (1) den vom oberen Element (3) und der mittleren Schicht (2) durchgelassenen Teil der umzuwandelnden Strahlung absorbiert und den restlichen Anteil in die darüber angeordnete mittlere Schicht (2) reflektiert,
- die mittlere Schicht (2) einen hohen Absorptionskoeffizienten für die umzuwandelnde Strahlung aufweist und
- das obere Element (3)
- der Absorption sowohl der von oben einfallenden umzuwandelnden Strahlung als auch der von den unteren Schichten kommenden Streustrahlung dient,
- die von den unteren Schichten reflektierte und im oberen Element (3) nicht absorbierte Streustrahlung in die unteren Schichten zurückreflektiert und
- eine geringe Reflexion für die von oben einfallende umzuwandelnde Strahlung aufweist.

2. Vorrichtung nach Anspruch 1,
**dadurch gekennzeichnet**,
daß die mittlere Schicht (2) Vertiefungen aufweist, und das obere Element (3) durch eine Beschichtung der Wände dieser Vertiefungen mit Metall gebildet wird.

3. Vorrichtung nach Anspruch 1,
**dadurch gekennzeichnet**,
daß das obere Element (3) aus einer Aluminiumschicht (7) mit durchgehenden Vertiefungen (8) und einer darauf abgeschiedenen dünnen Oxid-Schutzschicht besteht.

4. Vorrichtung nach einem der Ansprüche 1 bis 3,
**dadurch gekennzeichnet**,
daß untere Schicht (1), mittlere Schicht (2) und oberes Element (3) aus Materialien der CMOS-Technologie bestehen.

5. Vorrichtung nach einem der Ansprüche 1, 2 oder 4,
**dadurch gekennzeichnet**,
daß die untere Schicht (1) aus einer Aluminiumschicht mit einer Dicke von 1 µm, die mittlere Schicht (2) aus einer Oxidschicht mit einer Dicke von 2 bis 8 µm und das obere Element (3) aus einem Raster von Vertiefungen in der mittleren Schicht, deren Wände mit einer 500 nm dicken Aluminiumschicht bedeckt sind, bestehen, wobei die Ränder der Vertiefungen rechteckige Querschnitte mit einer Kantenlänge von 2 bis 4 µm aufweisen und in einem gegenseitigen Abstand von 2 bis 10 µm angeordnet sind.

6. Vorrichtung nach einem der Ansprüche 2, 4 oder 5,
**dadurch gekennzeichnet**,
daß die Vertiefungen des oberen Elementes mit einem Planarisierungsoxid (4) aufgefüllt sind.

## Claims

1. Device for converting infrared radiation into thermal energy for thermal detectors, comprising a support member (6) upon which there are applied from the support member a lower coating (1), a central coating (2) located on the lower coating (1) and an upper element (3) facing the impinging radiation, and located on the central coating (2),
- the lower coating (1) absorbing that proportion of the radiation to be converted which has been allowed through by the upper element (3) and the central coating (2) and reflecting the residual proportion into the central coating (2) located thereabove,
- the central coating (2) having a high coefficient of absorption for the radiation to be converted, and
- the upper element (3) serving to absorb both the radiation to be converted impinging from above and the scatter radiation coming from the lower coating,
- reflecting the scatter radiation reflected by the lower coatings and not absorbed in the upper element (3) back into the lower coatings, and
- having a low reflection f6r the radiation to be converted impinging from above.

2. Device according to Claim 1,
characterised in that
the central coating (2) has recesses, and the upper element (3) is formed by coating of the walls of these recesses with metal.

3. Device according to Claim 1,
characterised in that
the upper element (3) comprises an aluminium coating (7) with continuous recesses (8) and a thin oxide protective layer deposited thereon.

4. Device according to one of Claims 1 to 3,
characterised in that
the lower coating (1), the central coating (2) and the upper element (3) comprise materials from CMOS technology.

5. Device according to one of Claims 1, 2 or 4,
characterised in that
the lower coating (1) comprises an aluminium coating with a thickness of 1 µm, the central coating (2) an oxide coating with a thickness of 2 to 8 µm, and the upper element (3) a grid configuration of recesses in the central coating, whose walls are covered with an aluminium coating 500 nm thick, the edges of the recesses having rectangular cross-sections with an edge length of 2 to 4 µm, and being disposed at a mutual spacing apart at 2 to 10 µm.

6. Device according to one of Claims 2, 4 or 5,
characterised in that
the recesses in the upper element are filled with a planarising oxide (4).

## Revendications

1. Dispositif pour convertir un rayonnement infrarouge en énergie thermique pour des détecteurs thermiques, composé d'un support (6) sur lequel on réalise une couche inférieure (1), avec sur celle-ci une couche intermédiaire (2) et sur celle-ci un élément supérieur (3) tourné vers le rayonnement incident, dans lequel :
- la couche inférieure (1) absorbe la partie du rayonnement à convertir ayant traversé l'élément supérieur (3) et la couche intermédiaire (2), et réfléchit le reste dans la couche intermédiaire (2) se trouvant par-dessus,
- la couche intermédiaire (2) présente un coefficient d'absorption élevé pour le rayonnement à convertir, et
- l'élément supérieur (3) :
- sert à l'absorption à la fois pour le rayonnement incident à convertir, arrivant par le dessus, et pour le rayonnement dispersé provenant des couches inférieures,
- réfléchit en retour vers les couches inférieures le rayonnement dispersé réfléchi par les couches inférieures et non absorbé par l'élément supérieur (3) et
- possède une faible réflexion pour le rayonnement incident, venant du haut, à convertir.

2. Dispositif selon la revendication 1,
caractérisé en ce que
la couche intermédiaire (2) comporte des cavités et l'élément supérieur (3) est formé par un revêtement des parois de ces cavités avec du métal.

3. Dispositif selon la revendication 1,
caractérisé en ce que
l'élément supérieur (3) est une couche d'aluminium (7) avec des cavités contenues (8) et, sur celles-ci, une mince couche d'oxyde de protection, déposée.

4. Dispositif selon l'une des revendications 1 à 3, caractérisé en ce que
la couche inférieure (1), la couche intermédiaire (2) et l'élément supérieur (3) sont des matières de la technique CMOS.

5. Dispositif selon l'une des revendications 1, 2 ou 4,
caractérisé en ce que
la couche inférieure (1) est une couche d'aluminium d'une épaisseur de 1 µm, la couche intermédiaire (2) est une couche d'oxyde d'une épaisseur de 2 à 8 µm et l'élément supérieur (3) est formé d'une répartition en trame de cavités dans la couche intermédiaire, dont les parois sont revêtues d'une couche d'aluminium d'une épaisseur de 500 nm, les bords des cavités ayant des sections rectangulaires avec une longueur d'arête de 2 à 4 µm et un intervalle de 2 à 10 µm.

6. Dispositif selon l'une des revendications 2, 4 ou 5,
caractérisé en ce que
les cavités de l'élément supérieur sont remplies d'un oxyde planaire (4).
